# EUROPEAN PATENT APPLICATION

(11) **EP 1 726 991 A2**
(43) Date of publication of application: **29.11.2006**
(21) Application number: 06114426.7
(22) Date of filing: 23.05.2006
(51) Int. Cl.: G03F 7/00

(54) **Micro-contact-printing engine**

(30) Priority: 27.05.2005 GB 0510978
(71) Applicant: Microsaic Systems Limited, GU21 5BX Surrey Woking (GB)
(72) Inventor: Syms Richard, London SW7 2BT (GB)
(74) Representative: Hanna, Peter William Derek

(57) **Abstract**

This invention provides a method of accurately aligned, multilevel micro-contact-printing without the need for dedicated inking, alignment and stamping equipment. Die-sized micro-contact-printing engines are constructed from micromachined parts, which combine precision alignment features with stamper blocks supported on elastic suspensions. The stampers carry raised patterns, the alignment features mate with corresponding features on etched inkwells and substrates, and the pattern is transferred using a microactuator.

## Description

### Field of the Invention

This invention relates to contact printing of micron and submicron patterns, and in particular to patterns formed by the transfer of ink. The invention particularly relates to a MEMS device configured for providing such contact printing.

### Background

Microcontact printing (US 5,512,131; Kumar and Whitesides 1993) has allowed many new possibilities for patterning at the sub-micron scale. The starting point is a stamp, which is normally patterned non-photolithographically to achieve suitable resolution (Xia et al. 1996). The stamp material is often an elastomer with a low interfacial free energy such as polydimethylsiloxane (PDMS; Young's modulus ≈ 1 MPa) (Bender et al. 2004); however, the PDMS may be deposited on a rigid backing to improve pattern transfer (Odom et al. 2002). The stamp is then coated in an ink, often an alkanethiol consisting of an alkane (CₙH₂ₙ₊₂) terminated with a thiol group (SH), which adheres particularly well to metals. The stamp is contacted against a substrate to transfer the ink, which forms a self-assembled monolayer (SAM) (Xia, Zhai and Whitesides 1996). The SAM can act as a resist against wet or dry etching, to allow the pattern to be transferred to the substrate or an intermediate layer (Whidden et al. 1996). Suitable alkanethiols include hexadecanethiol, octadecanethiol, and eicosanethiol; lateral spreading of inked patterns is reduced with increasing molecular weight, since this reduces vapour pressure. The overall resolution is typically ≈ 100 nm.

Microcontact printing has been used to pattern many materials, both inorganic and organic. Of particular interest is its application in biochemistry, where the deposition of a micropatterned layer of protein (for example, fibronectin) has been used to immobilise biological cells on a surface for experimentation (Chen et. al. 1998). The protein is deposited by attachment to the surface of a suitably chosen SAM. Other applications in biochemistry include the functionalisation of individual sensor elements in a sensor array. This operation may require different sensitised layers to be deposited on different sites in sequence, and hence may require multiple aligned printing steps. In this case, it may be necessary to print on a fragile, non-planar substrate such as a cantilever array, if the transduction mechanism involves a change in resonance in a resonating system. Alternatively, it may be necessary to print on a fragile membrane, for example if the sensitised device acts as pre-concentrator operating by thermal desorption for another sensor type such as a mass spectrometer.

Microcontact printing has been adapted to non-planar surfaces (Jackman et al. 1995), cylindrical roller stamps have been developed (Xia, Qin and Whitesides 1996) and large-area patterning has been demonstrated with a contact mask aligner (Burgin et al. 2000). A variety of related techniques, including replica moulding, micro transfer moulding and solvent-assisted microcontact moulding have also been developed, and the general technique is termed "soft lithography" (Xia and Whitesides 1998).

A mask aligner typically contains an optical microscope to view the alignment of a pattern and a substrate, and a multi-axis positioning stage for adjustment of their relative positions. Although such equipment has been used for micro-contact-printing, the need to ink the stamper and then carry out layer-to-layer alignment without any contact prior to the final printing step makes multilayer patterning difficult, and it is hard to print on non-planar substrates. Furthermore, the cost of ownership of such equipment is a concern for some users, particularly biochemists. There is therefore a need for versatile, low-cost methods of performing inking and printing operations.

### Summary

These and other problems of micro contact printing described above are addressed in accordance with the present invention by using microelectromechanical systems (MEMS) technology to combine key mechanical features needed for alignment and printing in the stamper itself, in a miniaturised micro-contact-printing engine.

Accordingly the present invention provides for MEMS technology to be used to combine mechanical alignment features and an actuation mechanism with a patterned stamper in a miniature engine for micro-contact-printing. The alignment features mate directly with further alignment features formed on both the inkwell and the die itself, so that inking and printing are entirely self-aligned, obviating the need for a microscope, precision positioning stages, or precontact. A simple elastic suspension allows motion, and a micro-actuator provides actuation.

The invention therefore provides a micro-contact printing engine as claimed in claim 1. Advantageous embodiments are provided in the dependent claims thereto. The invention also provides a substrate as claimed in claim 19 with advantageous embodiments provided in the claims dependent thereto. The invention also provides a method of printing a pattern onto a substrate as claimed in claim 21 and a product of that process. The invention also provides a device, substrate and method substantially as hereinafter described with reference to the accompanying drawings.

These and other features of the invention will be better understood with reference to the exemplary embodiments which follow.

### Brief Description of the Drawings

Figure 1a) is a section view and Figure 1b) is a plan view of a micro-contact-printing engine in accordance with the teachings of the present invention.
Figure 2 shows in schematic form step-and-stamp ink patterning using a micro-contact-printing engine in accordance with the teachings of the present invention.
Figures 3a to 3c show in a schematic form a self-aligned inking process in accordance with the teachings of the present invention from the presentation of a printing engine to an inkwell provided on a substrate (Figure 3a) to the mating of co-operable alignment features provided on the substrate and the printing engine (Figure 3b) to the dipping of a stamper into ink provided in the well (Figure 3c).

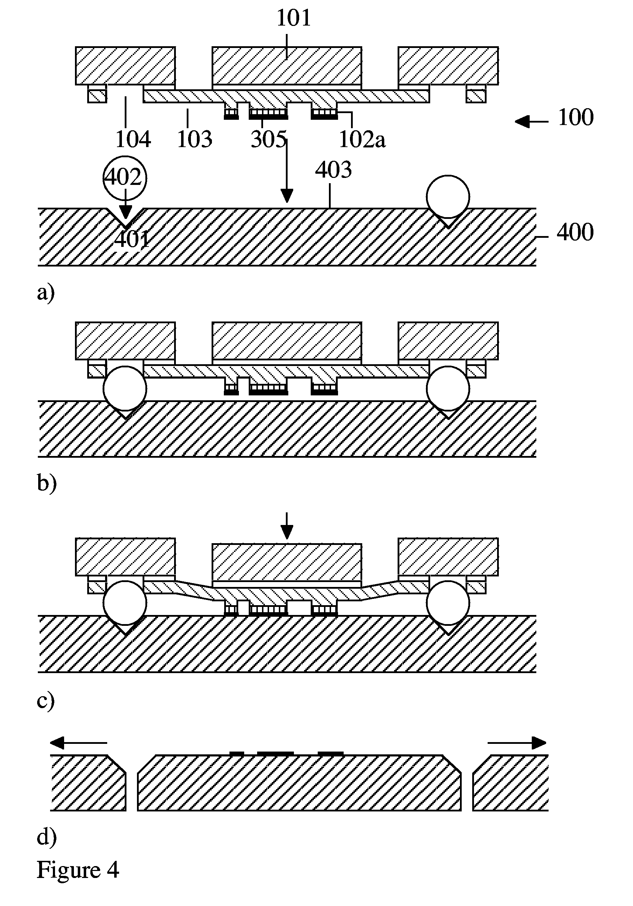

Figure 4 is a schematic of a self- aligned stamping process in accordance with the teachings of the present invention with Figure 4a) showing the presentation of an inked stamper to a desired print surface, Figure 4b) showing how alignment features of the stamper may be brought into contact with and seated upon alignment features of the second substrate, Figure 4c) showing how the stamper may be deflected downwardly so that inked surfaces are brought into contact with print surface and Figure 4d) shows how once printing is achieved how the stamper and alignment features may be taken away from the pattern site.
Figure 5a) shows actuation of a micro-contact-printing engine using a pneumatic actuator and
Figure 5b) shows the same actuation using an electrostatic microactuator, in accordance with the teachings of the present invention.
Figure 6 is an example of a process for fabrication of a micro-contact-printing engine from a bonded silicon-on-insulator wafer, in accordance with the teachings of the present invention

### Detailed description of the Drawings

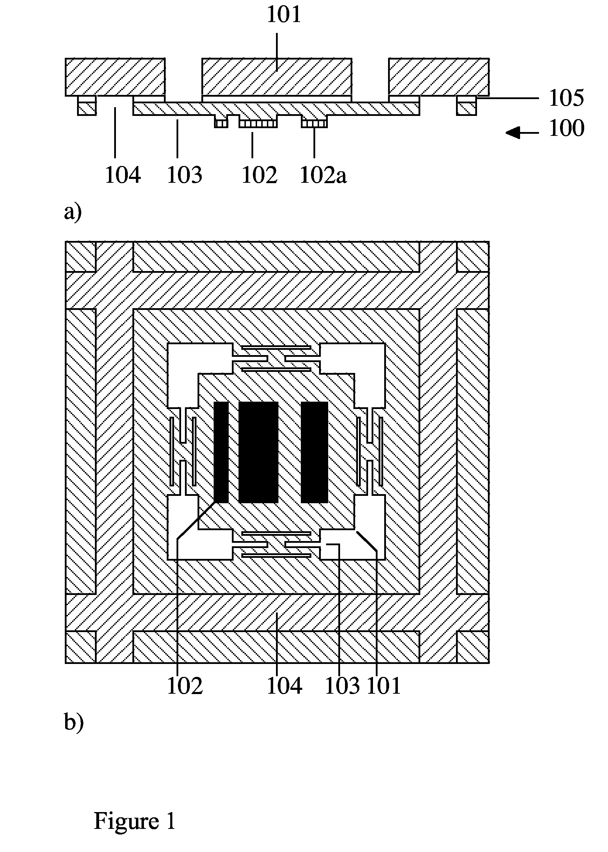

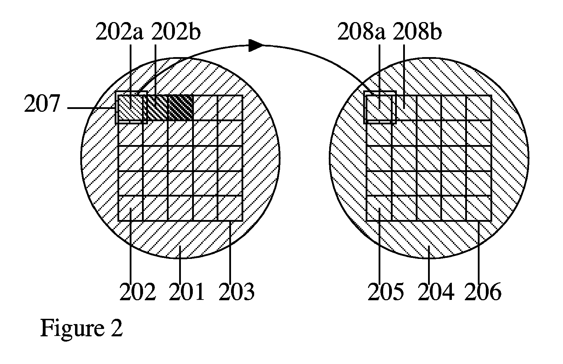

Figures 1 and 2 illustrate the concept of a micro-contact-printing engine implemented using MEMS technology in accordance with the present invention It will be appreciated by those skilled in the art that such technology uses a variety of methods to fabricate three-dimensional and movable microstructures, often in silicon or silicon-related materials. One such method is anisotropic etching down (111) planes of crystalline silicon (Bean 1978), which has beenused to form accurate V-shaped grooves for mounting optical fibres (Schroeder 1977). Other methods such as fusion bonding and deep reactive ion etching (Klaassen 1996) have vastly increased capabilities, allowing robust high-aspect ratio features to be formed in multilayers without restrictions from crystal orientation. A wide range of micro-actuators has also been developed. Conventionally, these combine an elastic suspension with a pneumatic, electrostatic, electrothermal, electromagnetic or piezoelectric drive (Fujita 1998). These and other methods of forming MEMS structures may equivalently be used within the context of the present invention to provide for micro-contact engines in accordance with the present invention.

Figure 1 shows a micro-contact-printing engine 100 in section (Figure 1a) and in plan (Figure 1b) view. The micro-contact-printing engine contains a movable block 101 carrying a print head 102 having a raised pattern defining a print surface 102a and supported on an elastic suspension system 103 allowing out-of-plane deflection. In this embodiment the block is separated from the print head by a buried oxide layer 105. The block and print head collectively provides a stamper element of the printing engine. Suitable elastic suspensions may include membranes, flexible beam elements and torsion bars. Here in this exemplary embodiment, a suspension consisting of sets of paired torsion bars 103 is shown. The stamper's surround contains a plurality of mechanical alignment features 104, which may mate with corresponding features on a separate substrate. It will be understood that at least one alignment feature is required and desirably at least two- one in each of the X and Y planes so as to correctly align the print engine relative to a substrate with which it is interacting. The alignment features is linked to the stamper element using the suspension system, and it will be appreciated that this link may be either a direct link (as shown in Figure 1a) or an indirect link where intervening components are located between the stamper element, the suspension system and the alignment feature.

Parts requiring mechanical rigidity (e.g. the stamper block and the surround) are formed in relatively thick layers of material, while flexible parts (e.g. the suspension) are formed in thinner layers.. It will be understood that the terms "thick" and "thinner" are not definite dimensions but what is intended by these terms is that the thickness is sufficient to provide rigidity of that the thinness is sufficient to enable the part to flex sufficiently. The pattern itself may be formed either in a hard material, typical examples being silicon or diamond, or in a soft material such as an elastomer, to allow conformal contact during printing. It will be appreciated that depending on the application for which the stamper is intended that different stampers may carry different patterns, and a number of stampers may be used to build up a complex pattern by overlay.

Figure 2 shows the operation of the micro-contact printing engine. Two additional types of substrate are required, each provided with a plurality of further mechanical alignment features that mate with alignment features on the stamper engine. The first substrate 201 contains a plurality of individual wells 202, each well being defined between each set of features or upstanding walls 203. Each well may be filled with different ink, to allow multilayer patterning. In this way a printing engine 207 may be dipped or brought into contact with a first well 202a containing a first ink. Once the print surface of that engine has been coated with ink and then used to pattern a first region 208a on the second substrate, a second print engine may be coated with ink from a second well 202b, and then used to pattern the same region or a different region 20 8b on that second substrate. In this way the multilayer print pattern on the second substrate may be developed. The second substrate 204 contains at least one print area 205, each print area being formed between each set of features 206 into which inked patterns may be transferred. The print areas of the second substrate may be provided in any topographical depending on the application to which it is intended. For example certain applications may require the application of ink onto a raised surface of the second substrate whereas other applications may require the application onto a recessed surface.
To ink the stamper, the micro-contact-printing engine is simply located over an appropriate inkwell 202 in the first substrate, so that the mechanical alignment features provided on the first substrate and the printing engine cooperate and interlock. At this point, there is no contact between the print pattern on the stamper and the surface of the ink, the stamper is in its first non-active position The stamper block is then deflected downwardly into the ink to coat the stamper. This second position is its active position. The deflection of the stamper downwardly may be achieved in a plurality of different ways, examples of which will be described later.

To transfer the pattern, the micro-contact-printing engine with the coated stamp is then relocated over an appropriate die site 208 on the second substrate, so that the mechanical alignment features of the second substrate and those of the print engine interlock. At this point, there is again no contact between the stamper pattern and the printing site, the stamper is in its first non-active position The stamper block is then deflected down once more to adopt its second active position but in this instance is not taking up ink but rather transferring ink on the print pattern so as to generate an inked pattern on the second substrate.

Because the mechanical features on the micro-contact-printing engine interlock with those on the inkwells and die sites, the process is entirely self-aligning, and it is possible to locate and overlay patterns with high precision. Relocation of the micro-contact-printing engine between different inkwells and printing sites may be carried out manually or using automated equipment. The printing site may be non-planar, and may carry previously fabricated movable structures such as cantilever arrays, merely provided alignment features that allow mating with the micro-contact-printing engine are incorporated. The printing of this highly defined pattern on the second substrate enables the development of highly defined areas of controlled wettability on the second substrate. In this context the areas of wettability are useful in a variety of applications such as for example the provisions or sensors (or sensor arrays) where areas of specific wettability are provided for sensing specific constituents or products.

It will be appreciated by those skilled in the art that a range of different mechanical alignment features may be used to provide a kinematic location mount. Suitable features include but are not restricted to V-grooves, U-grooves, pyramidal cavities, spherical cavities, and spherical objects and cylindrical objects that are inserted into such grooves and cavities to lock them together. Each offers different advantages. For example, Figure 1 shows U-shaped alignment grooves 104 formed in the stamper part; this geometry allows the suspension and the alignment grooves to be formed in a single step.

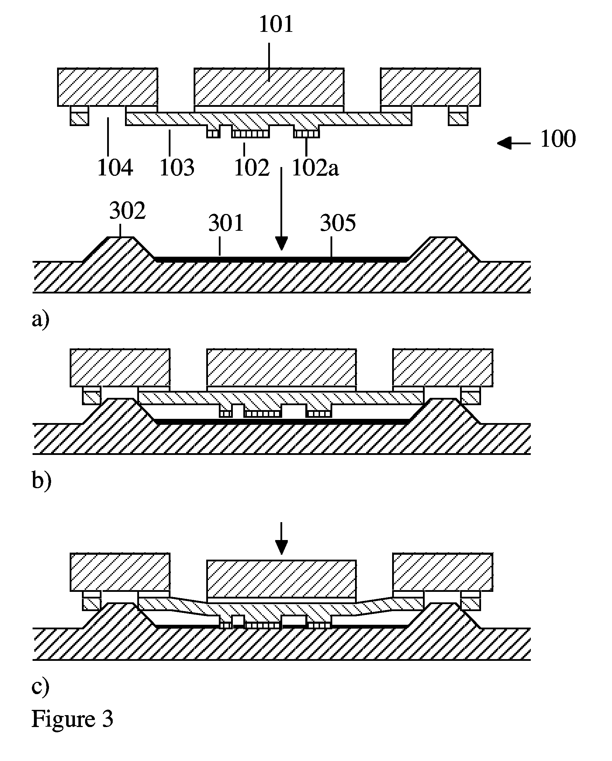

Figures 3 and 4 show other possibilities for mechanical alignment features. For example, Figure 3 shows inkwells 301 bounded by V-shaped rails 302; this geometry conveniently allows inkwells to be formed with closed sides to contain ink 305. Alignment features of this type have been used in the construction of miniature, self-aligning optical fibre connectors (Holmes and Syms 1989) and electrical connectors (Larsson and Syms 2004), where high alignment accuracy is required, but heretofore have not been considered for use in printing applications..

In Figure 3, which shows the sequence of steps that may be used to provide ink on the stamper, a printing engine is first presented to an inkwell provided on a substrate (Figure 3a). On correct presentation the engine is lowered so that alignment features on the engine mate with cooperating alignment features on the substrate (Figure 3b). Once correct alignment has been achieved, the stamper is then deflected downwardly into the inkwell 301 so as to achieve a coating of ink on a lower surface 102a of the stamper.

Once a coating of ink has been achieved it is then necessary to transfer the ink to the desired site. One way of achieving this transfer is illustrated using a sequence of steps shown in Figure 4. In Figure 4 die locations defined by V-shaped alignment grooves 401, provided within the substrate 400, are loaded with short sections of material with a cylindrical cross-section 402 to locate with the alignment features 104 of the stamper. Alignment features of this type have been used in the construction of miniature, self-aligning quadrupole electrostatic lenses (Syms et al. 1998), where high alignment accuracy is again required. If the substrate is crystalline, this approach allows a convenient method of die separation by cleaving after completion of the inking process. Pyramidal pits and spherical inserts offer, it will be appreciated by those skilled in the art, asimilar alternative. The sequence of steps is as follows. In Figure 4a) an inked stamper 100 is presented to a desired print surface or pattern location 403 on a substrate 400. The pattern location is desirably defined between two alignment features 401 which provide for alignment in two dimensions. The cylindrical cross-section elements 402 are located into their respective grooves 401. These may be simply positioned into the groove separately to the step of presenting the stamper or could be previously incorporated with the stamper and then the two are presented as a single unit to the second substrate. In Figure 4b) the former of these two options is described where the alignment features 104 of the stamper are brought into contact with and seated upon the already located cylindrical elements 402. Once seated, the stamper is deflected downwardly so that the inked surfaces 102a are brought into contact with the surface of the pattern location 403 (Figure 4c)). Once patterning is achieved, typically after a predefined period of time of contact sufficient to enable a transfer of ink from the print element of the stamper to the substrate, the stamper is taken away from the pattern site and the cylindrical elements are also removed (Figure 4d)).

For biological applications, where low cost, transparent substrates are often required, suitably grooved or indented substrates may be prepared by etching of a glass or by replication of etched silicon masters by moulding of a plastic.

The initial separation between the stamper and the base of the ink well or the copy plate is determined with high precision by the geometry of the mechanical alignment system. The stamper stroke must at least equal this separation to allow printing to be carried out. The stamper motion may be monitored: either externally, for example by optical means, or be measured internally, for example by a strain sensor built into the elastic suspension, to allow the protection of fragile substrates containing features such as cantilevers or membranes.

Actuation of the stamper may be carried out by any of the methods previously demonstrated in MEMS. These methods include, but are not restricted to, manual, pneumatic, electrostatic, electromagnetic and piezoelectric actuation.

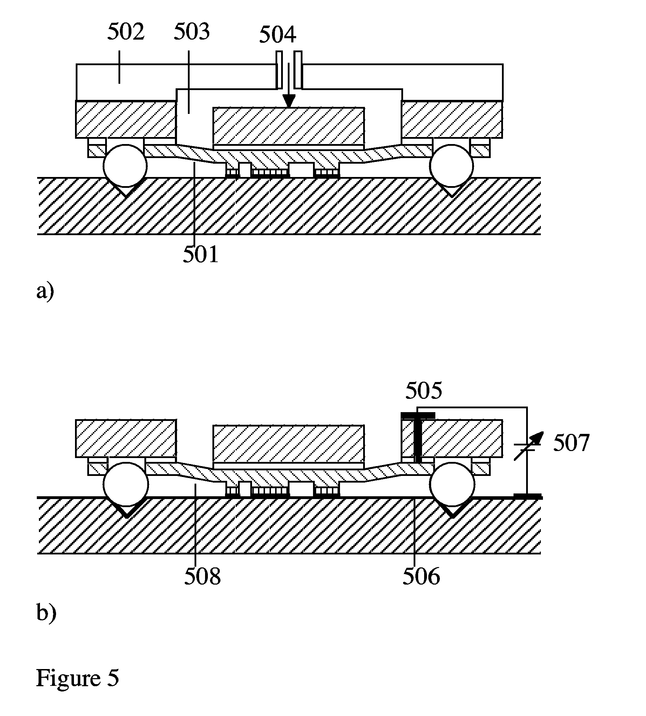

For example, Figure 5a shows pneumatic actuation, which simply requires a continuous membrane suspension 501 and the addition of a backing part 502 forming a plenum chamber 503 into which air may be pumped at modest pressure via an inlet 504. Pneumatic actuation has the advantage of being self-contained, and may be used with arbitrary substrates. However, the requirement for a relatively wide membrane suspension leads to a reduction in the patternable area.

Similarly, Figure 5b shows electrostatic actuation, which requires the provision of a contact 505 to a conducting stamper block and a conducting layer 506 to the substrate, so that a voltage 507 may be applied between them. The conducting layer may be formed from a metal or from a conducting oxide such as indium tin oxide if transparency is required. In this case, a more compact elastic suspension 508 may be used, for example but not exclusively in the form of a plurality of paired torsion bars 103 as shown in Figure 1b. The use of a compact suspension allows an increase in the patternable area for a given overall die size and stamper stroke. However, the conducting layer needed for electrostatic operation may be incompatible with some applications.

It will be appreciated by those skilled in the art that a piezo-electric drive may also be used for actuation provided suitable piezoelectric materials (for example, lead zirconate titanate, or PZT) and electrodes are incorporated in the elastic suspension. Similarly, a magnetic drive may be used provided suitable magnetic materials (for example, permalloy) are incorporated in the stamper block and an external electrical coil is provided.

It will also be appreciated by those skilled in the art that a micro-contact-printing engine as described in the present invention may be formed in a variety of materials. Materials compatible with common micromachining processes include but are not restricted to single crystal silicon, and multilayer wafers containing single-crystal silicon layers. One example of a suitable multilayer material is bonded silicon-on-insulator (BSOI). This material consists of an oxidised silicon wafer, to which has been bonded a further silicon layer so that the oxide layer is sandwiched between two layers of silicon. The silicon layers may conveniently be structured by anisotropic etching down crystal planes, and also by deep reactive ion etching (DRIE), a method of near vertical etching that is carried out in a high density inductively-coupled plasma (Hynes et al. 1999). The oxide interlayer provides a convenient etch stop.

It will also be appreciated by those skilled in the art that a variety of different fabrication steps may be used and combined in a variety of different orders to form micro-contact-printing engines as described in the present invention. Here we give one example of a fabrication process that is illustrative and exemplary of the sequence steps that may be utilised to form a printing engine in accordance with the invention but is not intended to limit the invention to such steps.

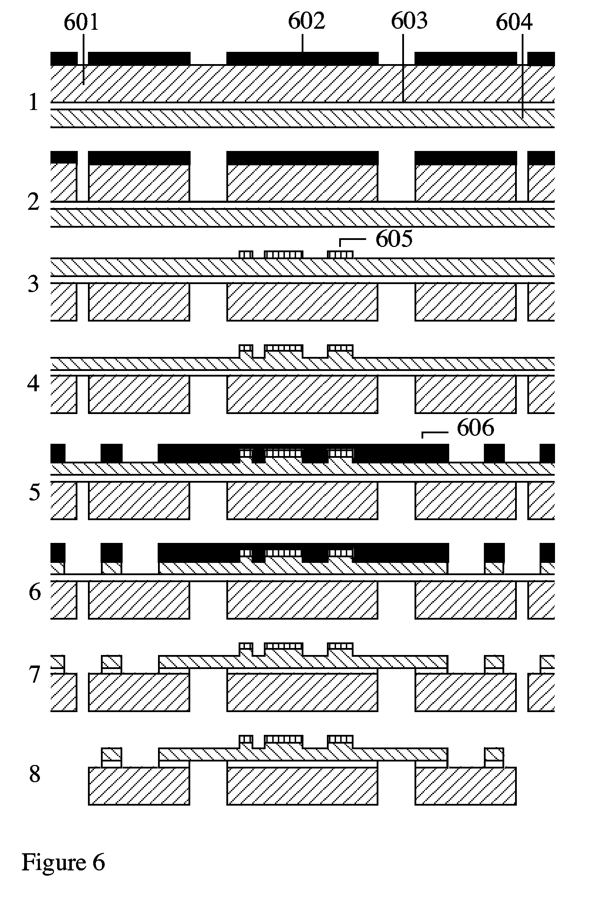

Figure 6 shows a process in which the parts are formed in a BSOI wafer by DRIE. The substrate 601 is first pattered lithographically with thick resist 602 to define the overall stamp layout (step 1), and this pattern is transferred down to the buried oxide layer 603 by deep reactive ion etching (step 2). The resist is then removed.

The substrate is then turned over, and the bonded silicon layer 604 is patterned to define the stamp pattern in a layer of soft material 605, for example, using optical or electron beam lithography followed by reactive ion etching (steps 3 and 4). Alternative non-lithographic methods such as transfer moulding may also be used. Suitable soft materials include but are not restricted to PDMS and SU-8, an epoxy-based resist (Lorenz 1997).

The bonded silicon layer is then patterned with a second layer of thick resist 606 to define the suspension and alignment grooves (step 5), and this pattern is then transferred down to the buried oxide layer by DRIE (step 6). Remaining photoresist is then removed, together with exposed areas of oxide (step 7), and stamper dies are separated for use (step 8).

Provision of an electrical contact to the stamper block requires further process steps of patterning, etching, and metallisation that are obvious to those skilled in the art. Provision of a strain sensor to monitor the motion of the stamper block requires further process steps of patterning and etching of a deposited film or patterning and diffusion of a dopant to provide a strain-sensitive resistor that are again well-known in the art.

As mentioned above, the use of a print engine in accordance with the teachings of the present invention enables the provision of high density print patterns on a substrate. Depending on the ink used, such print patterns may be used for a variety of applications including the development of sensors. As the alignment achievable using the techniques of the invention enables highly accurate printing, it is possible to create different regions of sensitivity on a sensor substrate, or regions that are suited for one specific species vis a vis another. If the ink selected is a conductive ink it is possible to provide micro-circuits on the substrate. Such print arrays it will therefore be appreciated may have a myriad of different applications in fields as diverse as biosensors and electronics.

It will be appreciated that what has been described herein is a printing engine formed using MEMS technology, and as such is a MEMS device. The print engine includes a stamper block that is mountable on a flexible, elastic mounting arrangement that enables the stamper to be moved, on suitable actuation, from a first postion where it is not in contact with a substrate to a second position where it is in contact. The movement of the stamper block can be controlled to ensure that the block is firstly adequately dipped in an ink and secondly that the inked block is presented correctly to a substrate where it is used to print specific patterns. By incorporating one or more alignment features within the print engine and having the stamper moveable relative to the alignment features it is possible to self-align the stamper relative to its intended stamping location.

It will therefore be understood that although the invention has described a specific method of accurately aligned, multilevel micro-contact-printing without the need for dedicated inking, alignment and stamping equipment that this method is exemplary of the techniques of the invention. In accordance with the teachings of the invention die-sized micro-contact-printing engines are constructed from micromachined parts, which combine precision alignment features with stamper blocks supported on elastic suspensions. The stampers carry raised patterns, the alignment features mate with corresponding features on etched inkwells and substrates, and the pattern is transferred using a microactuator.

While the invention has been described with reference to specific embodiments it will be appreciated that these are exemplary embodiments only and that modifications to that illustrated will be apparent to those skilled in the art without departing from the spirit or scope of the invention. Where one or more integers or components are described with reference to one specific Figure it will be appreciated that these integers or components may be substituted with other integers or components. Furthermore, although the invention has been described with regard to an implementation in silicon, that the application of the MEMS techniques of the present invention are not intended to be limited to any one specific material.

Similarly, the words comprises/comprising when used in this specification are to specify the presence of stated features, integers, steps or components but does not preclude the presence or addition of one or more other features, integers , steps, components or groups thereof.

### References

1. Kumar A., Whitesides G.M. "Formation of microstamped patterns on surfaces and derivative articles" US 5,512,131 April 30 (1996)
2. Kumar A., Whitesides G.M. "Features of gold having micrometer to centimeter dimensions can be formed through a combination of stamping with an elastomeric stamp and an alkanethiol ink followed by chemical etching" Appl. Phys. Letts. 63, 2002-2004 (1993)
3. Xia Y.N., Tien J., Qin D., Whitesides G.M. "Non-photolithographic methods for fabrication of elastomeric stamps for use in microcontact printing" Langmuir 12, 4033 - 4038 (1996)
4. Bender M., Plachetka U., Ran J., Fuchs A., Vratzov B., Kurz H., Glinsner T., Lindner F. "High resolution lithography with PDMS molds" J. Vac. Sci. Tech. B 22, 3229-3232 (2004)
5. Odom T.W., Love J.C., Wolfe D.B., Paul K.E., Whitesides G.M. "Improved pattern transfer in soft lithography using composite stamps" Langmuir 18, 5314-5320 (2002)
6. Xia Y.N., Zhai X.M., Whitesides G.M. "Pattern transfer: self-assembled monolayers as ultrathin resists" Microelectr. Engng. 32, 255-268 (1996)
7. Whidden T.K., Ferry D.K., Kozicki M.N., Kim E., Kumar A., Wilbur J., Whitesides G.M. "Pattern transfer to silicon by microcontact printing and RIE" Nanotechnology 7, 447-451 (1996)
8. Chen C.S., Mrksich M., Huang S., Whitesides G.M., Ingber D.E. "Micropatterned surfaces for control of cell shape, position and function" Biotechnology Progress 14, 356-363 (1998)
9. Jackman R.J., Wilbur J., Whitesides G.M. "Fabrication of submicron features on curved substrates by microcontact printing" Science 269, 664-666 (1995)
10. Xia Y., Qin D., Whitesides G.M. "Microcontact printing with a cylindrical rolling stamp: a practical step toward automatic manufacturing of patterns with submicrometer-sized features" Adv. Mater. 8,1015-1017 (1996)
11. Burgin T., Choong V.E., Maracas G. "Large area submicrometer contact printing using a contact aligner" Langmuir 16, 5371-5375 (2000)
12. Xia Y.N., Whitesides G.M. "Soft lithography" Angew. Chemie 37, 551-575 (1998)
13. Bean K.E. "Anisotropic etching of silicon" IEEE Trans. Electron Devices ED-25, 1185-1193 (1978)
14. Schroeder C.M. "Accurate silicon spacer chips for an optical fiber cable connector" Bell. Syst. Tech. J. 57, 91-97 (1977)
15. Klaassen E.H., Petersen K., Noworolski J.M., Logan J., Maluf N.I., Brown J., Storment C., McCulley W., Kovacs T.A. "Silicon fusion bonding and deep reactive ion etching: a new technology for microstructures" Sensors and Actuators A52, 132-139 (1996)
16. Fujita H. "Microactuators and micromachines" Proc. IEEE 86, 1721-1732 (1998)
17. Holmes A.S., Syms R.R.A. "Self- aligning guided wave breadboard system for delay line signal processing" Proc. 7th Int. Conf. on Fibre Optics and Optoelectronics, April 25-27, London, Pp 3.4-3.9 (1989)
18. Larsson M.P., Syms R.R.A. "Self-aligning MEMS in-line separable connector" IEEE/ASME J. Microelectromech. Syst. 13, 365-376 (2004)
19. Syms R.R.A., Tate T.J., Ahmad M.M., Taylor S. "Design of a microengineered quadrupole electrostatic lens" IEEE Trans. on Electron Devices TED-45, 2304-2311 (1998)
20. Hynes A.M., Ashraf H., Bhardwaj J.K., Hopkins J., Johnston I., Shepherd J.N. "Recent advances in silicon etching for MEMS using the ASE™ process" Sensors and Actuators 74, 13-17 (1999)
21. Lorenz H., Despont M., Fahrni N., LaBianca N., Renaud P., Vettinger P. "SU 8: a low-cost negative resist for MEMS" J. Micromech. Microeng. 7, 121-124 (1997)

## Claims

1. A micro-contact-printing engine comprising:
a print surface linked to at least one mechanical alignment feature by an elastic suspension, the suspension enabling a movement of the print surface relative to the at least one alignment feature from a non-active position to an active position.

2. A micro-contact engine as claimed in claim 1 wherein the print surface is defined by a raised pattern provided on a first planar surface.

3. A micro- contact engine as claimed in claim 2 wherein the alignment feature is provided on a second planar surface.

4. A micro-contact engine as claimed in claim 3 wherein the elastic suspension links the first surface to the second surface.

5. A micro-contact-printing engine as in any preceding claim in which the print surface is used to transfer ink from an inkwell provided on a first substrate onto a second substrate.

6. A micro-contact-printing engine as in Claim 5 in which the at least one alignment feature is configured to mate with a corresponding mechanical alignment features on the first substrate or on the second substrate.

7. A micro-contact-printing engine as in any preceding claim in which the print surface is formed in an elastic material.

8. A micro-contact-printing engine as in any preceding claim wherein the alignment features consist of one of:
a. mating grooves and rails,
b. mating grooves and cylinders,
c. mating pits and spheres, or
d. a suitable combination thereof.

9. A micro-contact-printing engine as in Claim 2 in which the elastic suspension allows motion of the first planar surface in a direction perpendicular to that surface.

10. A micro-contact printing engine as in any preceding claim, in which the elastic suspension is formed from a membrane, a set of flexible beams, a set of torsion bars, or any suitable combination thereof.

11. A micro-contact-printing engine as in any preceding claim, in which the elastic suspension carries a strain sensor.

12. A micro-contact printing engine as in any preceding claim, in which movement of the print surface relative to the at least one alignment feature is actuated manually, pneumatically, electrostatically, electromagnetically or piezoelectrically.

13. A micro- contact printing engine as in any preceding claim, which is formed from a crystalline material wherein the crystalline material may be silicon or a layered material containing silicon.

14. A micro-contact printing engine as claimed in any preceding claim wherein the print surface defines a pattern.

15. A micro-contact-printing engine as in claim 14, in which the pattern, suspension and alignment features are defined by optical lithography or by electron beam lithography.

16. A micro-contact-printing engine as in any one of Claims 1 to 14 in which the pattern is defined by transfer moulding.

17. A micro-contact-printing engine as in any one of Claims 1 to 14, in which the suspension and alignment features are formed by an etching process or by a moulding process.

18. A micro- contact printing engine as claimed in any preceding claim wherein the print surface is linked directly or indirectly to the at least one mechanical alignment feature.

19. A substrate having a defined print surface onto which a print pattern may be printed, the substrate further having at least one mechanical alignment feature defined therein, the at least one alignment feature being configured to cooperate with a corresponding alignment feature provided on a micro-contact printing engine, the co-operation of the corresponding at least one alignment features on both of the substrate and the micro-contact printing engine providing for alignment of the micro-contact printing engine relative to the print surface and subsequent accurate printing of the printing pattern on the surface.

20. The substrate as claimed in claim 19 having a print pattern printed onto the print surface, the print pattern defining at least one sensor, or the print pattern defining conductive tracks on the surface.

21. A method of printing a print pattern on a substrate, the method including the steps of:
a. Providing a MEMS device configured as a micro-contact printing engine, the engine comprising a print surface linked to at least one mechanical alignment feature by an elastic suspension, the suspension enabling a movement of the print surface relative to the at least one alignment feature from a non-active position to an active position,
b. Providing a first substrate, the first substrate having an inkwell provided on an surface thereof, the substrate also having at least one mechanical alignment feature defined in that surface,
c. Providing a second substrate, the second substrate having an print area provided on an surface thereof, the substrate also having at least one mechanical alignment feature defined in that surface,
d. Presenting the micro-contact printing engine to the first substrate and mating the alignment features of each of the micro-contact printing engine and the substrate prior to moving the print surface into the inkwell from its non-active position to its active position so as to achieve an inking of the print surface, and
e. Presenting the micro-contact printing engine with the inked print surface to the second substrate and mating the alignment features of each of the micro-contact printing engine and the substrate prior to moving the print surface onto the print surface from its non-active position to its active position so as to apply a print pattern on the print area.
